(19) **Europäisches Patentamt**

**European Patent Office**

**Office européen des brevets**

(11) **EP 0 779 704 B1**

(12) **FASCICULE DE BREVET EUROPEEN**

(45) Date de publication et mention
de la délivrance du brevet:
**29.08.2001 Bulletin 2001/35**

(51) Int Cl.⁷: $H03D\ 7/18$, $H03D\ 7/16$

(21) Numéro de dépôt: **96402716.3**

(22) Date de dépôt: **12.12.1996**

(54) **Dispositif mélangeur à réjection de fréquence image**

Mischereinrichtung mit Beseitigung der Spiegelfrequenz

Image rejection mixer

(84) Etats contractants désignés:
**AT BE CH DE FI GB IT LI NL SE**

(30) Priorité: **15.12.1995 FR 9514927**

(43) Date de publication de la demande:
**18.06.1997 Bulletin 1997/25**

(73) Titulaire: **MATRA NORTEL COMMUNICATIONS**
**29000 Quimper (FR)**

(72) Inventeurs:
• **Guegnaud, Hervé**
**78390 Maurepas (FR)**

• **Robbe, Michel**
**78700 Conflans Sainte Honorine (FR)**

(74) Mandataire: **Loisel, Bertrand et al**
**Cabinet Plasseraud,**
**84, rue d'Amsterdam**
**75440 Paris Cédex 09 (FR)**

(56) Documents cités:
**EP-A- 0 344 467**      **EP-A- 0 573 247**
**FR-A- 2 625 630**

## Description

La présente invention telle qu'elle est définie dans les revendications concerne un dispositif mélangeur pour le traitement d'un signal radio. Un tel dispositif peut notamment être utilisé dans le premier étage de réception d'un récepteur de radiocommunication. Le signal radio traité peut être un signal à modulation par déplacement de phase (PSK) ou à modulation par déplacement de fréquence (FSK) (les modulations FSK peuvent être considérées comme des cas particuliers de modulations PSK).

Le dispositif mélangeur sert à extraire à une fréquence intermédiaire $f_I$ une phase modulée que présente le signal radio reçu à une fréquence de communication $f_C$. On utilise pour cela une fréquence de transposition $f_0$ fournie par un oscillateur local, égale à la somme ou à la différence entre la fréquence de communication $f_C$ et la fréquence intermédiaire $f_I$. Or, le signal radio capté a généralement un large spectre, et possède a priori des composantes à la fréquence $f_0+f_I$ et à la fréquence $f_0-f_I$. L'une de ces deux fréquences est la fréquence de communication désirée $f_C$, tandis que l'autre est une fréquence image $2f_0-f_C$ que le dispositif doit rejeter pour que sa phase ne perturbe pas la phase modulée à la fréquence $f_C$ qu'on cherche à extraire.

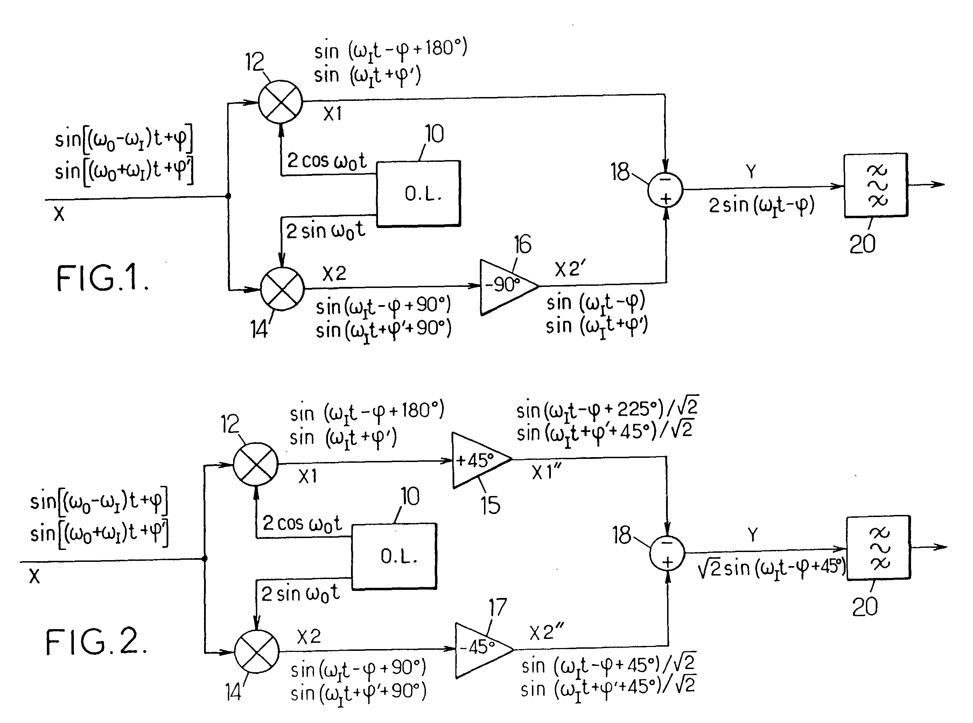

La figure 1 montre un agencement classique d'un dispositif à réjection de fréquence image. Un oscillateur local 10 fournit deux ondes en quadrature à la fréquence de transposition $f_0=\omega_0/2\pi$, qui sont chacune mélangées au signal d'entrée X par des mélangeurs respectifs 12, 14. Pour la fréquence intermédiaire $f_I=\omega_I/2\pi$, le signal radio X possède deux composantes à considérer, l'une notée $\sin[(\omega_0-\omega_I)t+\varphi]$ et l'autre notée $\sin[(\omega_0+\omega_I)t+\varphi']$. On suppose ici que la fréquence de communication désirée $f_C$ est $(\omega_0-\omega_I)/2\pi$ et que la fréquence $(\omega_0+\omega_I)/2\pi$ est la fréquence image indésirable. La phase modulée qu'on cherche à extraire est alors la phase $\varphi$. Le signal de sortie X1 du mélangeur 12, résultant du mélange du signal radio X par l'onde $2\cos\omega_0 t$, possède deux composantes à la fréquence intermédiaire $f_I$ : l'une présentant la phase $-\varphi+180°$ et l'autre présentant la phase $\varphi'$. Le signal de sortie X2 du mélangeur 14, résultant du mélange du signal radio X par l'onde $2\sin\omega_0 t$ qui a un retard de phase de 90° par rapport à l'onde $2\cos\omega_0 t$, possède également deux composantes à la fréquence intermédiaire : l'une présentant la phase $-\varphi+90°$ et l'autre présentant la phase $\varphi'+90°$. Un filtre déphaseur 16 applique au signal X2 un retard de phase de 90° à la fréquence intermédiaire, pour produire un signal X2' ayant, à la fréquence intermédiaire, une composante de phase $-\varphi$ et une composante de phase $\varphi'$. Un soustracteur 18 retranche le signal X1 de ce signal déphasé X2'. La phase indésirable $\varphi'$ est ainsi éliminée du signal de sortie Y du soustracteur 18. Il ne subsiste que la phase désirée $\varphi$ (affectée d'un signe moins dans ce cas particulier). Le signal de sortie Y est appliqué à un filtre passe-bande 20 qui laisse passer les composantes de fréquence proche de la fréquence intermédiaire $f_I$ pour extraire la phase désirée.

L'inconvénient majeur du dispositif représenté sur la figure 1 est le besoin d'un déphaseur de 90° nécessitant deux pôles et devant généralement être réalisé sous forme de composants discrets. En outre, les chemins suivis par les deux signaux combinés par le soustracteur 18 ne sont pas identiques, ce qui affecte l'efficacité de la réjection.

Pour réduire l'incidence de ces problèmes, il a été proposé de remplacer le déphaseur de 90° par deux déphaseurs de $\pm45°$. La figure 2 montre un tel agencement. Le déphaseur 15 applique une avance de phase de 45° au signal X1 pour produire un signal X1" ayant, à la fréquence intermédiaire, une composante de phase $-\varphi+225°$ et une composante de phase $\varphi'+45°$. Le déphaseur 17 applique un retard de phase de 45° au signal X2 pour produire un signal X2" ayant, à la fréquence intermédiaire, une composante de phase $-\varphi+45°$ et une composante de phase $\varphi'+45°$. Le signal de sortie $Y=X2"-X1"$ du soustracteur 18 possède alors à la fréquence intermédiaire une seule composante de phase $-\varphi+45°$, c'est-à-dire contenant l'information utile. On note que l'amplitude de ce signal Y est plus petite que celle obtenue avec le schéma de la figure 1, étant donné l'atténuation de $\sqrt{2}$ apportée par les déphaseurs de $\pm45°$ 15, 17.

Le dispositif de la figure 2 améliore celui de la figure 1, notamment en ce qu'il est réalisable sous forme d'un circuit intégré. Mais il n'est pas dépourvu d'inconvénients. En particulier, la construction des deux réseaux RC constituant les filtres déphaseurs 15, 17 est délicate. L'appariement de ces deux réseaux est délicat et nécessite des compensations. En général, l'une des capacités n'est pas flottante, et il est donc nécessaire de tenir compte de sa capacité parasite, par exemple en plaçant en amont des filtres déphaseurs des étages suiveurs à faible impédance de sortie. Pour obtenir une réjection suffisamment efficace, les réseaux déphaseurs doivent le plus souvent être ajustés au moyen de convertisseurs numérique-analogique. En outre, le dispositif doit constamment s'adapter aux évolutions de l'environnement (température, tension d'alimentation...) de façon à optimiser la réjection d'image.

Le document EP-A-0 344 467 divulgue un autre exemple de dispositif de réception à réjection de fréquence-image.

Un but de la présente invention est de proposer une structure simplifiée pour un dispositif mélangeur à réjection de fréquence image pouvant être réalisé entièrement sous forme d'un circuit intégré.

L'invention propose ainsi un dispositif mélangeur à réjection de fréquence image, comprenant des moyens de mélange pour former un premier signal par mélange d'un signal radio d'entrée avec une première onde de fréquence $f_0$ fournie par un oscillateur local et un second signal par mélange du signal radio d'entrée avec une seconde onde de fréquence $f_0$ fournie par l'os-

cillateur local et ayant un retard de phase de 90° par rapport à ladite première onde, et des moyens de sommation algébrique de troisième et quatrième signaux mutuellement déphasés obtenus à partir desdits premier et second signaux, pour produire un signal de sortie possédant, à la fréquence intermédiaire $f_I$, une phase représentative de la phase que possède le signal radio d'entrée à une fréquence de communication $f_C$ de la forme $f_0-f_I$ ou $f_0+f_I$, avec réjection de la phase que peut posséder le signal radio d'entrée à la fréquence image $2f_0-f_C$. Selon l'invention, le dispositif comprend en outre des moyens déphaseurs produisant ledit troisième signal par filtrage d'une somme algébrique des premier et second signaux avec une fonction de transfert A(f), et des moyens pour produire ledit quatrième signal en appliquant à l'un desdits premier et second signaux une fonction de transfert B(f) telle que, à la fréquence intermédiaire $f_I$, le rapport $A(f_I)/B(f_I)$ soit de module $1/\sqrt{2}$ et d'argument $\pm 45°$ ou $\pm 135°$.

Par "somme algébrique" de deux signaux, on entend ici la somme ou la différence des deux signaux en question.

L'invention sera mieux comprise à la lecture de la description ci-après d'exemples de réalisation préférés mais non limitatifs, en référence aux dessins annexés, dans lesquels :

- les figures 1 et 2 sont des schémas synoptiques de dispositifs mélangeurs à réjection de fréquence image de l'art antérieur ;
- les figures 3 à 10 sont des schémas synoptiques de huit dispositifs mélangeurs selon l'invention ;
- la figure 11 est un schéma de principe d'un dispositif du type montré sur la figure 3 ;
- la figure 12 est un diagramme de phase illustrant le fonctionnement du dispositif de la figure 11 ;
- la figure 13 est un schéma détaillé d'un dispositif selon la figure 7 ; et
- la figure 14 est un schéma d'un circuit d'asservissement utilisable avec un dispositif selon la figure 13.

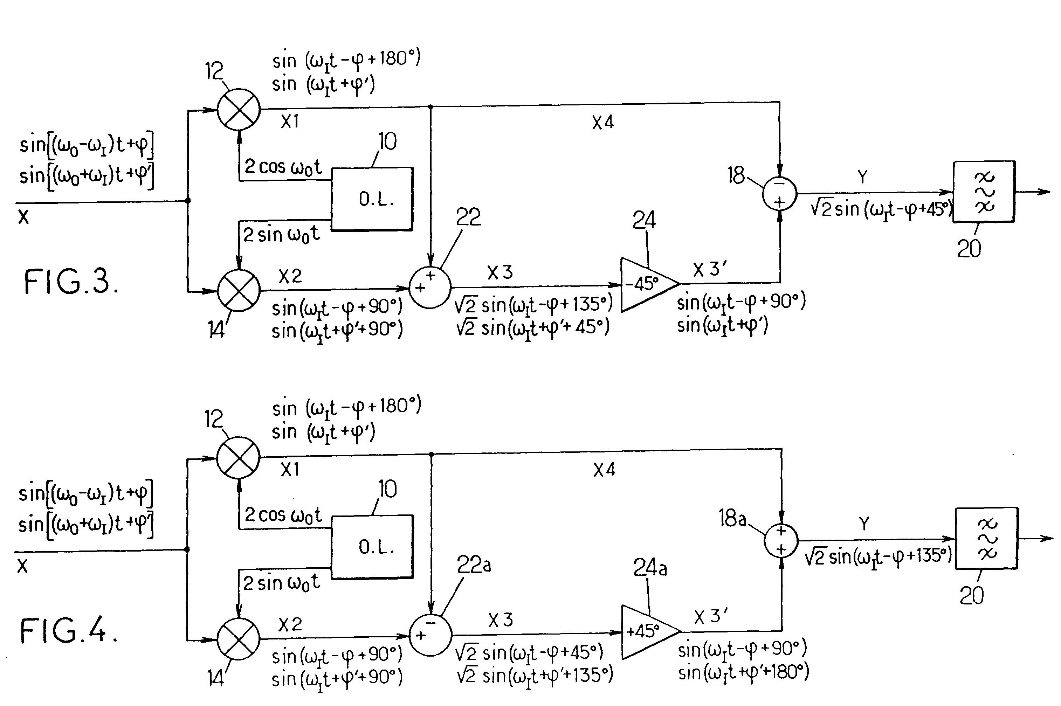

Sur les figures 3 à 10, les mêmes références numériques que sur les figures 1 et 2 ont été utilisées pour désigner des éléments identiques, notamment l'oscillateur local 10 et les mélangeurs 12, 14. Pour faciliter la comparaison avec les figures 1 et 2, on considère, pour les figures 3 à 10, le cas où la fonction de transfert ci-dessus appelée B(f) vaut 1.

Dans le dispositif représenté sur la figure 3, un additionneur 22 produit la somme X3 du premier signal X1 fourni par le mélangeur 12 et du second signal X2 fourni par le mélangeur 14. Le signal X3 présente un gain de $\sqrt{2}$ à la fréquence intermédiaire étant donné qu'il correspond à une somme de deux vecteurs en quadrature. A la fréquence intermédiaire $f_I$, le signal X3 possède une phase de $-\varphi+135°$ et une phase de $\varphi'+45°$. Un filtre déphaseur 24 applique un déphasage au signal X3 pour produire un signal X3'. Ce déphasage correspond à un retard de phase de 45° à la fréquence intermédiaire $f_I$, de sorte que le signal X3' possède, à la fréquence intermédiaire $f_I$, une phase de $-\varphi+90°$ et une phase de $\varphi'$. L'atténuation de $\sqrt{2}$ introduite par le filtre déphaseur 24 à la fréquence intermédiaire compense le gain de $\sqrt{2}$ du signal X3. Le soustracteur 18 réalise la différence entre le signal X3' et un signal X4=B(f) .X1=X1. Dans cette différence Y, la phase indésirable $\varphi'$ a été éliminée. Il ne subsiste, à la fréquence intermédiaire $f_I$, que la phase $-\varphi+45°$, avec un gain de $\sqrt{2}$ étant donné que le soustracteur 18 réalise une somme de deux signaux en quadrature $\sin(\omega_I t-\varphi)$ et $\sin(\omega_I t-\varphi+90°)$. Le signal de sortie Y du dispositif mélangeur peut ensuite être appliqué au filtre passe-bande 20 pour les traitements ultérieurs.

Dans le dispositif représenté sur la figure 4, l'additionneur 22 est remplacé par un soustracteur 22a produisant la différence X3=X2-X1, le filtre déphaseur 24a introduit une avance de phase de +45° à la fréquence intermédiaire pour produire le signal X3' à partir du signal de différence X3, et le soustracteur 18 est remplacé par un additionneur 18a produisant Y=X3'+X4=X3'+X1. Dans ce cas, le signal X3 possède, à la fréquence intermédiaire, les phases $-\varphi+45°$ et $\varphi'+135°$, de sorte que le signal déphasé X3' possède, à la fréquence intermédiaire, les phases $-\varphi+90°$ et $\varphi'+180°$. En conséquence, la phase indésirable $\varphi'$ est éliminée du signal de sortie Y, qui ne présente, à la fréquence intermédiaire, que la phase $-\varphi+135°$ représentative de la phase $\varphi$ que possède le signal d'entrée X à la fréquence de communication $f_C=f_0-f_I$.

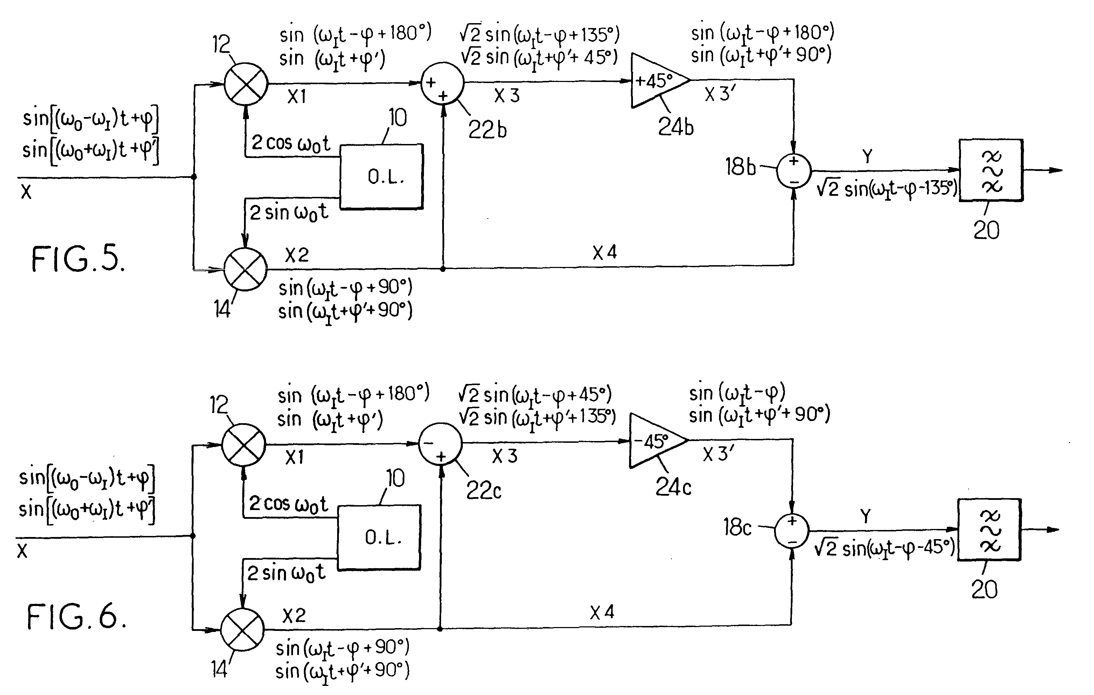

Dans le dispositif schématisé sur la figure 5, l'additionneur 22b produit le signal X3=X1+X2 possédant, à la fréquence intermédiaire, les phases $-\varphi+135°$ et $\varphi'+45°$. Le filtre déphaseur 24b applique au signal X3 un déphasage de +45° pour produire un signal X3' ayant, à la fréquence intermédiaire, les phases $-\varphi+180°$ et $\varphi'+90°$. Le soustracteur 18b produit un signal de sortie Y=X3'-X4=X3'-X2 possédant seulement la phase $-\varphi-135°$ à la fréquence intermédiaire.

Dans le dispositif représenté sur la figure 6, le soustracteur 22c produit le signal X3=X2-X1 possédant, à la fréquence intermédiaire, les phases $-\varphi+45°$ et $\varphi'+135°$. Le déphaseur 24c applique au signal X3 un déphasage de -45° à la fréquence intermédiaire pour produire un signal X3' ayant, à la fréquence intermédiaire, les phases $-\varphi$ et $\varphi'+90°$. Le soustracteur 18c produit un signal de sortie Y=X3'-X4=X3'-X2 ayant seulement la phase $-\varphi-45°$ à la fréquence intermédiaire.

Dans les explications données ci-dessus en référence aux figures 3 à 6, le "premier signal" X1 a été obtenu en mélangeant au signal radio d'entrée X une onde $2\cos\omega_0 t$ qui est en avance de phase de 90° par rapport à l'onde $2\sin\omega_0 t$ mélangée au signal radio d'entrée pour former le "second signal" X2. Ceci permet d'extraire à la fréquence intermédiaire une phase représentative de la phase $\varphi$ que possède le signal radio d'entrée à une fréquence de communication $f_C=f_0-f_I$, en re-

jetant la fréquence image $2f_0-f_C=f_0+f_I$.

Dans les cas où la fréquence de communication $f_C$ est de la forme $f_0+f_I$, c'est la phase $\varphi'$ qu'on souhaite extraire à la fréquence intermédiaire, en éliminant la fréquence image $2f_0-f_C=f_0-f_I$. Dans ce cas, il convient de permuter les rôles des signaux X1 et X2.

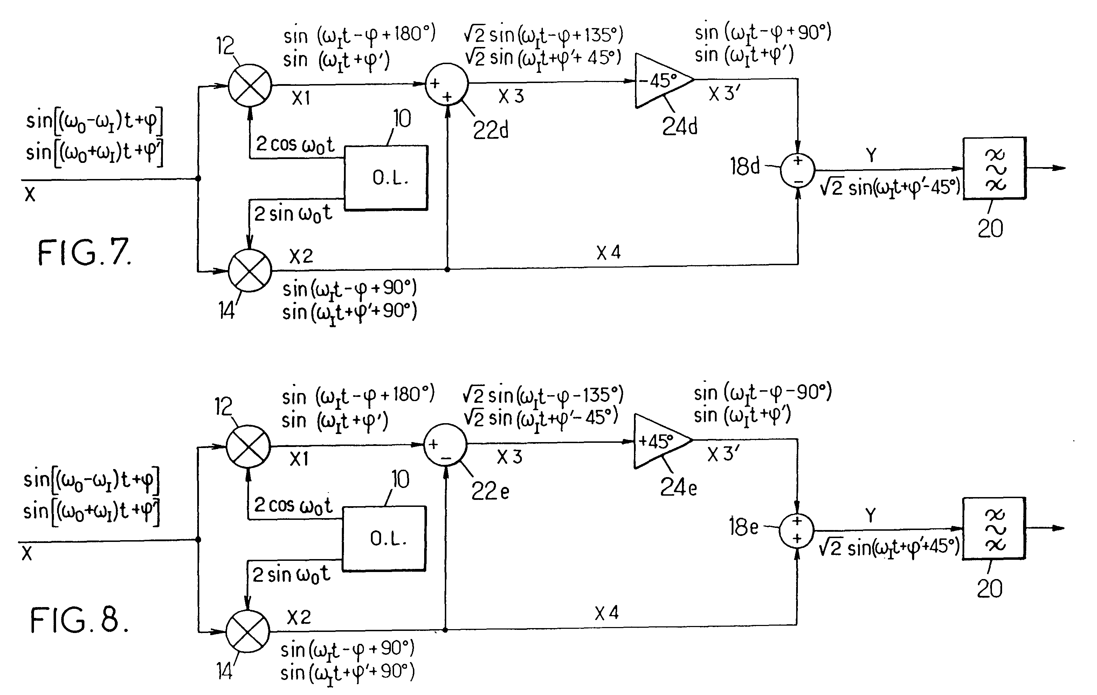

Les figures 7 à 10 sont ainsi des schémas de dispositifs respectivement semblables à ceux des figures 3 à 6, dans lesquels les rôles des signaux X1 et X2 ont été permutés dans les combinaisons effectuées pour fournir le signal de sortie Y, et convenant donc pour une fréquence de communication $f_C=f_0+f_I$ avec réjection de la fréquence image $f_0-f_I$.

Dans le dispositif de la figure 7, le déphaseur 24d retarde de 45° la phase du signal X3=X1+X2 produit par l'additionneur 22d. Le soustracteur 18d soustrait le signal X4=X2 de la sortie X3' du déphaseur 24d pour que le signal de sortie Y ait seulement la phase $\varphi'-45°$ à la fréquence intermédiaire.

Dans le dispositif de la figure 8, le déphaseur 24e avance de 45° la phase du signal X3=X1-X2 produit par le soustracteur 22e. L'additionneur 18e ajoute le signal X4=X2 à la sortie X3' du déphaseur 24e pour que le signal de sortie Y ait seulement la phase $\varphi'+45°$ à la fréquence intermédiaire.

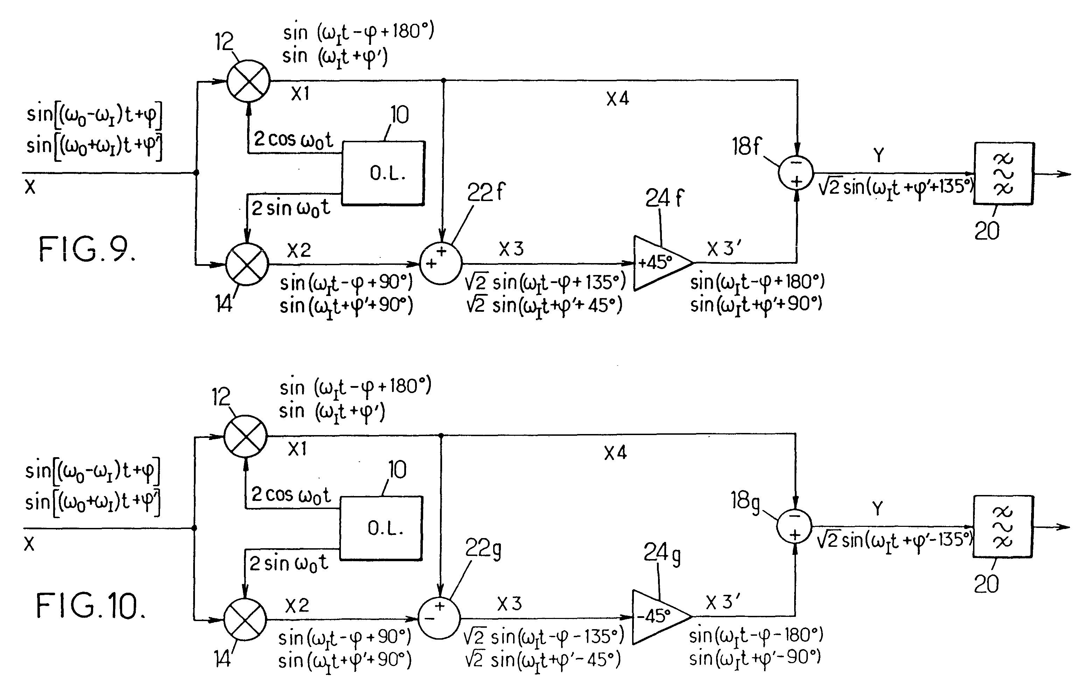

Dans le dispositif de la figure 9, le déphaseur 24f avance de 45° la phase du signal X3=X1+X2 produit par l'additionneur 22f. Le soustracteur 18f soustrait le signal X4=X1 de la sortie X3' du déphaseur 24f pour que le signal de sortie Y ait seulement la phase $\varphi'+135°$ à la fréquence intermédiaire.

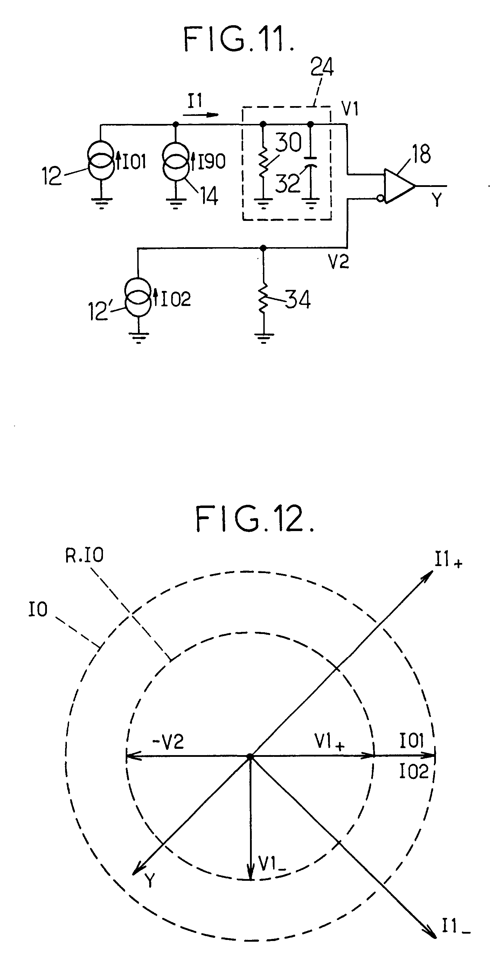

Dans le dispositif de la figure 10, le déphaseur 24g retarde de 45° la phase du signal X3=X1-X2 produit par le soustracteur 22g. Le soustracteur 18g soustrait le signal X4=X1 de la sortie X3' du déphaseur 24g pour que le signal de sortie Y ait seulement la phase $\varphi'-135°$ à la fréquence intermédiaire.

Dans le cas général, lorsque la fréquence de communication $f_C$ est de la forme $f_0-f_I$, la combinaison appliquée aux signaux X1 et X2 pour produire le signal de sortie Y est telle que Y soit la partie réelle d'un signal complexe proportionnel à $(X1+X2)e^{-j\pi/4}/\sqrt{2}-X1$ (figure 3), à $(X2-X1)e^{j\pi/4}/\sqrt{2}+X1$ (figure 4), à $(X1+X2)e^{j\pi/4}/\sqrt{2}-X2$ (figure 5), ou à $(X2-X1)e^{-j\pi/4}/\sqrt{2}-X2$ (figure 6). Les figures 3 à 6 correspondent au cas où la constante de proportionnalité vaut 1. Dans le cas général, cette constante de proportionnalité peut être tout nombre complexe $B(f_I)$.

Lorsque la fréquence de communication $f_C$ est de la forme $f_0+f_I$, la combinaison appliquée aux signaux X1 et X2 pour produire le signal de sortie Y est telle que Y soit la partie réelle d'un signal complexe proportionnel à $(X1+X2)e^{-j\pi/4}/\sqrt{2}-X2$ (figure 7), à $(X1-X2)e^{j\pi/4}/\sqrt{2}+X2$ (figure 8), à $(X1+X2)e^{j\pi/4}/\sqrt{2}-X1$ (figure 9), ou à $(X1-X2)e^{-j\pi/4}/\sqrt{2}-X1$ (figure 10). Les figures 7 à 10 correspondent au cas où la constante de proportionnalité vaut 1. Dans le cas général, cette constante de proportionnalité peut être tout nombre complexe $B(f_I)$.

Comme $e^{3j\pi/4}=-e^{-j\pi/4}$ et $e^{-3j\pi/4}=-e^{j\pi/4}$, les déphasages précités, obtenus par des filtres déphaseurs de $\pm45°$ à la fréquence intermédiaire dans les schémas des figures 3 à 10, pourraient également être obtenus par des filtres déphaseurs de $\pm135°$ à la fréquence intermédiaire, moyennant une modification correspondante des signes dans les sommes algébriques.

La figure 11 montre un schéma de principe d'une forme de réalisation d'un dispositif mélangeur selon la figure 3, dans lequel les premier et second signaux X1, X2 sont produits, sont forme de signaux de courant. Sur la figure 11, les mélangeurs 12, 14 sont schématisés par des générateurs de courant délivrant des courants I01 et I90 de même amplitude I0 et correspondant respectivement aux signaux X1 et X2. Il est prévu une duplication du générateur 12. Ainsi, le générateur 12' délivre un courant I02 égal au courant I01. La somme I1=I01+I90 des courants produits par les générateurs 12, 14, qui représente le signal X3, est appliquée à une première borne commune d'une résistance 30 et d'un condensateur 32 constituant le filtre déphaseur 24. La résistance 30 et le condensateur 32 sont montés en parallèle entre cette première borne et une seconde borne portée à un potentiel de référence, par exemple un potentiel positif ou, comme représenté, le potentiel de la masse. La valeur ohmique R de la résistance 30 et la capacité C du condensateur 32 sont réglées pour vérifier la relation $RC\omega_I=1$, de sorte que le filtre RC 24 introduit un retard de phase de 45° à la fréquence intermédiaire $f_I=\omega_I/2\pi$ entre la tension V1 à la première borne, qui représente le signal X3', et le courant I1 injecté par les générateurs 12, 14 à cette première borne. En notations complexes, on a V1=R.I1/(1+j) à la fréquence intermédiaire, soit $X3'=R.X3.e^{-j\pi/4}/\sqrt{2}$. Le dispositif comporte encore une résistance 34 de même valeur ohmique R que la première résistance 30, connectée entre la seconde borne au potentiel de référence et une troisième borne où est injecté le courant I02 produit par le générateur 12'. La tension V2=R.I02 présente à cette troisième borne, qui représente le signal X4, est donc en phase avec le signal X1 que représente le courant I02 : X4=R.X1. Le soustracteur 18 produit alors le signal $Y=R[(X1+X2)e^{-j\pi/4}/\sqrt{2}-X1]$ par différence entre les signaux de tension V1 et V2. Les fonctions de transfert A(f) et B(f) sont dans ce cas des impédances telles que B(f)=R et $A(f_I)=R.e^{-j\pi/4}/\sqrt{2}$.

Si, à la fréquence intermédiaire $f_I$, le courant I90 est en avance de phase de 90° par rapport aux courants I01 et I02, le courant $I1_+=I01+I90=(1+j)I01$ présente un déphasage de +45° par rapport aux courants I01 et I02 (figure 12). La tension $V1_+=R.I1_+/(1+j)=R.I01$ qui en résulte a alors la même amplitude et la même phase que la tension V2, de sorte que ces deux tensions s'annulent en sortie du soustracteur 18. Cette situation est celle des composantes $\sin(\omega_I t+\varphi')$ et $\sin(\omega_I t+\varphi'+90°)$ des signaux X1 et X2 (figure 3).

Si, à la fréquence intermédiaire $f_I$, le courant I90 a un retard de phase de 90° par rapport aux courants I01 et I02, la somme $I1\_=I01+I90=(1-j)I01$ présente un déphasage de $-45°$ par rapport aux courants I01 et I02. La tension $V1\_=R.I1\_/(1+j)=-j.I01$ qui en résulte a la même amplitude que la tension V2, avec un déphasage de $-90°$ (figure 12). Le signal de sortie $Y=V1\_-V2$ est alors non nul. En notations complexes, $Y=R.(-1-j).I01$. Cette situation est celle des composantes $\sin(\omega_I t-\varphi+180°)$ et $\sin(\omega_I t-\varphi+90°)$ des signaux X1 et X2 (figure 3).

Le schéma de principe de la figure 11, présenté dans le cas d'un dispositif mélangeur selon la figure 3, est manifestement transposable à des dispositifs mélangeurs selon les figures 4 à 10.

On voit donc qu'un dispositif selon l'invention peut être réalisé de façon particulièrement simple en utilisant un filtre déphaseur consistant en un simple réseau RC parallèle sans capacité flottante, la somme algébrique schématisée par les sommateurs 22, 22a-g sur les figures 3 à 10 pouvant être réalisée simplement par injection de deux courants à une borne de ce réseau RC.

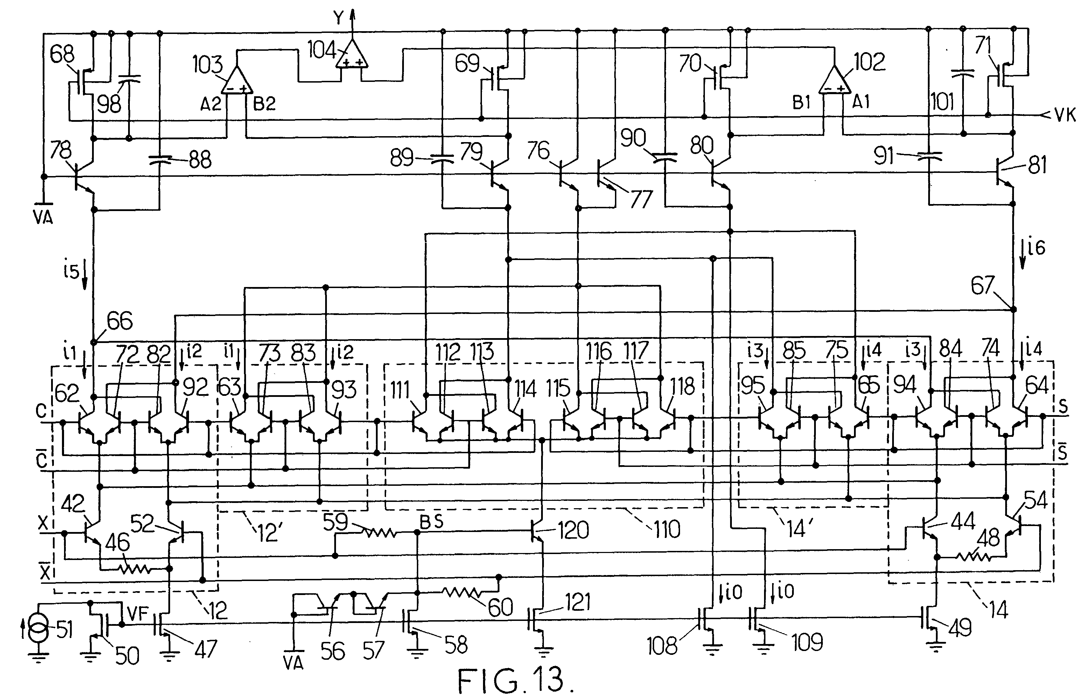

La figure 13 montre un mode de réalisation d'un dispositif mélangeur selon la figure 7, dans lequel les signaux sont des signaux différentiels, la fréquence de communication étant de la forme $f_C=f_0+f_I$ (par exemple $f_0=30,6\text{ MHz}$, $f_I=10,7\text{ MHz}$ et $f_C=41,3\text{ MHz}$). Les mélangeurs 12, 14 sont constitués par des cellules de Gilbert à transistors npn.

La cellule 12 comprend un premier étage de deux transistors npn 42, 52 dont les émetteurs sont reliés par une résistance de linéarisation 46 dont la valeur pourrait être nulle, la base du transistor 42 recevant le signal radio d'entrée X, et la base du transistor 52 recevant l'opposé $\bar{X}$ de ce signal X. Le drain d'un transistor NMOS 47 est relié à l'émetteur du transistor npn 52. Ce transistor 47 est agencé pour délivrer un courant constant, par exemple de 60 µA. Pour cela, sa source est reliée à la masse, et sa grille est portée à une tension fixe VF présente sur la connexion commune drain-grille d'un autre transistor NMOS 50 polarisé à saturation, avec sa source à la masse. Un générateur de courant 51 injecte un courant stable pour polariser le transistor 50. La cellule 12 comprend un second étage de quatre transistors npn 62, 72, 82, 92. Les émetteurs des transistors 62, 72 sont reliés au collecteur du transistor 42, tandis que les émetteurs des transistors 82, 92 sont reliés au collecteur du transistor 52. Les bases des transistors 62 et 92 reçoivent un signal C de tension sinusoïdale à la fréquence $f_0$ issu de l'oscillateur local 10 (onde $\cos\omega_0 t$), tandis que les bases des transistors 72 et 82 reçoivent un signal $\bar{C}$ de tension sinusoïdale à la fréquence $f_0$ issu de l'oscillateur local 10 et correspondant au signal C déphasé de $180°$. Les collecteurs des transistors 62 et 82 sont reliés entre eux, de même que ceux des transistors 72 et 92.

Avec cet agencement, la cellule de Gilbert 12 délivre le signal mélangé X1 sous la forme de la différence entre le courant i1 issu des collecteurs des transistors 62, 82 et le courant i2 issu des collecteurs des transistors 72, 92 : $X1=i1-i2$. Ce signal différentiel X1 est

proportionnel à $X.\cos\omega_0 t$.

La cellule 14 a une structure analogue à celle de la cellule 12, avec un premier étage de deux transistors npn 44, 54 dont les émetteurs sont reliés par une résistance de linéarisation 48, la base du transistor 44 recevant le signal radio d'entrée X, et la base du transistor 54 recevant le signal $\bar{X}$. Le drain d'un transistor NMOS 49 identique au transistor 47 est relié à l'émetteur du transistor npn 44. Ce transistor 49 a sa source reliée à la masse, et sa grille reçoit la même tension constante VF que celle du transistor 47. Pour équilibrer les cellules, les collecteurs des transistors 42, 44 sont reliés entre eux, de même que les collecteurs des transistors 52, 54. La cellule 14 comprend un second étage de quatre transistors npn 64, 74, 84, 94. Les émetteurs des transistors 64, 74 sont reliés au collecteur du transistor 54, tandis que les émetteurs des transistors 84, 94 sont reliés au collecteur du transistor 44. Les bases des transistors 64 et 94 reçoivent un signal S de tension sinusoïdale à la fréquence $f_0$ issu de l'oscillateur local 10 et correspondant au signal C avec un retard de phase de $90°$ (onde $\sin\omega_0 t$), tandis que les bases des transistors 74 et 84 reçoivent un signal $\bar{S}$ de tension sinusoïdale à la fréquence $f_0$ et correspondant au signal S déphasé de $180°$. Les collecteurs des transistors 64 et 84 sont reliés entre eux, de même que ceux des transistors 74 et 94.

Avec cet agencement, la cellule de Gilbert 14 délivre le signal mélangé X2 sous la forme de la différence entre le courant i3 issu des collecteurs des transistors 74, 94 et le courant i4 issu des collecteurs des transistors 64, 84 : $X2=i3-i4$. Ce signal différentiel X2 est proportionnel à $X.\sin\omega_0 t$, la constante de proportionnalité étant la même que celle du signal différentiel X1 délivré par la cellule 12.

Pour la polarisation des transistors 42, 52, 44, 54, les signaux de tension X et $\bar{X}$ sont superposés à une tension continue BS avant: d'être adressés aux bases des transistors 42, 44 et 52, 54. Cette tension BS est produite par deux transistors npn en série 56, 57 montés en diode. Le transistor 56 a son collecteur et sa base reliés à une borne d'alimentation à une tension positive VA. Le transistor 57 a son collecteur et sa base reliés à l'émetteur du transistor 56, et son émetteur relié au drain d'un transistor NMOS 58. La source du transistor 58 est à la masse et sa grille à la tension VF. La tension BS, présente sur l'émetteur du transistor 57, est alors $BS=VA-2V_{be}$, où $V_{be}$ est la tension de saturation base-émetteur des transistors 56, 57. Pour polariser les transistors des premiers étages des cellules de Gilbert, l'émetteur du transistor 57 est relié aux bases des transistors 42, 44 et 52, 54 par l'intermédiaire de résistances de polarisation respectives 59 et 60.

Pour réaliser l'addition schématisée par l'additionneur 22d sur la figure 7, les courants i1 et i3 sont injectés à un noeud commun 66, et les courants i2 et i4 sont injectés à un noeud commun 67. Ainsi, le signal X3 représenté sur la figure 7 est le signal de courant différentiel correspondant à la différence entre le courant i5=i1+i3 issu du noeud 66 et le courant i6=i2+i4 issu du noeud 67 : X3=i5-i6.

Pour délivrer la seconde version du signal X2 qui sera combinée au signal déphasé de 45°, le second étage de la cellule de Gilbert 14 est dupliqué. Il est ainsi prévu un étage 14' consistant en quatre transistors npn 65, 75, 85, 95 connectés de la même manière que les transistors 64, 74, 84, 94 du second étage de la cellule 14. Une seconde version des courants i3 et i4 est ainsi disponible sur la connexion commune des collecteurs des transistors 75, 95 et sur la connexion commune de collecteurs des transistors 65, 85.

Pour des raisons de symétrie, on prévoit également une duplication du second étage de la cellule de Gilbert 12. L'étage 12' est ainsi constitué de quatre transistors npn 63, 73, 83, 93 connectés de la même manière que les transistors 62, 72, 82, 92 du second étage de la cellule 12. Une seconde version des courants i1 et i2 est ainsi disponible sur la connexion commune des collecteurs des transistors 63, 83 et sur la connexion commune des collecteurs des transistors 73, 93.

Le dispositif mélangeur de la figure 13 comprend encore quatre transistors PMOS 68, 69, 70, 71 polarisés pour fonctionner dans leur zone ohmique, et quatre transistors npn 78, 79, 80, 81 en montage cascode. Les sources des transistors PMOS 68-71 et les bases des transistors npn 78-81 sont chacune à la tension d'alimentation positive VA. Les drains des transistors 68, 69, 70, 71 sont respectivement reliés aux collecteurs des transistors 78, 79, 80, 81. L'émetteur du transistor 78 reçoit le courant i5 issu du noeud 66. L'émetteur du transistor 79 reçoit le courant i3 issu des collecteurs des transistors 75, 95 de l'étage 14'. L'émetteur du transistor 80 reçoit le courant i4 issu des collecteurs des transistors 65, 85 de l'étage 14'. L'émetteur du transistor 81 reçoit le courant i6 issu du noeud 67. Les émetteurs des transistors 78, 79, 80, 81 sont par ailleurs reliés à la borne où est présente la tension d'alimentation VA par l'intermédiaire de condensateurs de filtrage respectifs 88, 89, 90, 91.

Les résistances des canaux des transistors 68, 71 jouent un rôle semblable à celui de la résistance 30 de la figure 11, tandis que les canaux des transistors 69, 70 jouent un rôle semblable à celui de la résistance 34 sur la figure 11. Les valeurs de résistance de ces canaux des transistors 68-71 sont fixées par une tension de réglage VK adressée aux grilles de ces transistors. Les canaux des transistors 68, 71 sont connectés en parallèle avec des condensateurs respectifs 98, 101 jouant le rôle du condensateur 32 de la figure 11.

On note respectivement A1, A2, B1, B2, les tensions sur les drains des transistors PMOS 71, 68, 70, 69. La tension différentielle A1-A2 correspond au signal déphasé noté X3' sur la figure 7, et la tension différentielle B1-B2 correspond au signal noté X4 sur la figure 7. Les moyens correspondant au soustracteur 18d de la figure 7 sont agencés pour délivrer le signal de sortie Y donné par Y=A1-A2-B1+B2. Dans l'exemple représenté sur la figure 13, ces moyens comprennent deux amplificateurs différentiels 102, 103 suivis par un amplificateur additionneur 104 délivrant le signal Y. L'amplificateur différentiel 102 a une entrée positive recevant la tension A1 et une entrée négative recevant la tension B1, tandis que l'amplificateur différentiel 103 a une entrée positive recevant la tension B2 et une entrée négative recevant la tension A2. Les sorties des deux amplificateurs différentiels 102, 103 sont reliées aux entrées de l'amplificateur additionneur 104.

Avec le circuit représenté sur la figure 13, on a A1(f)=-$Z_A$(f).i6(f), A2(f)=-$Z_A$(f).i5(f), B1(f)=-$Z_B$(f).i4(f), et B2(f)=-$Z_B$(f).i3(f), où A1(f), A2(f), B1(f), B2(f), et i3(f) à i6(f) désignent les composantes de Fourier à la fréquence f des signaux A1, A2, B1, B2, et i3 à i6, et $Z_A$(f), $Z_B$(f) désignent les impédances complexes :

$$Z_A(f) = \frac{R_0}{1+2\pi j R_0 (C_0+C_p)f}$$

$$Z_B(f) = \frac{R_1}{1+2\pi j R_1 C_p f}$$

$R_0$ désignant la résistance des canaux des transistors PMOS 68, 71, $R_1$ désignant la résistance des canaux des transistors PMOS 69, 70, $C_0$ désignant la capacité des condensateurs 98, 101, et $C_p$ désignant une capacité parasite due essentiellement au collecteur de chacun des transistors npn 78-81 ($C_p$ est une capacité entre un collecteur et la borne de référence à la tension VA). L'une des raisons pour lesquelles on utilise l'étage de transistors en cascode 78-81 est qu'il permet de réduire ces capacités parasites : chaque entrée des amplificateurs différentiels 102, 103 "voit" une seule capacité parasite $C_p$ correspondant au collecteur du transistor 78-81 auquel elle est reliée, au lieu de plusieurs si les entrées des amplificateurs différentiels étaient directement reliées aux collecteurs des transistors des cellules de Gilbert. La valeur de la capacité parasite $C_p$ peut être connue avec une précision raisonnable au moyen de simulations du comportement électronique du circuit intégré (elle est typiquement de l'ordre de 10% de $C_0$).

Comme X3'(f)=A1(f)-A2(f)=$Z_A$(f).[i5(f)-i6(f)] =$Z_A$(f).X3(f) et X4(f)=B1(f)-B2(f)=$Z_B$(f).[i3(f)-i4(f)] =$Z_B$(f).X2(f), les impédances complexes $Z_A$(f) et $Z_B$(f) sont les fonctions de transfert A(f) et B(f) entre les signaux différentiels X3 et X3' et entre les signaux différentiels X2 et X4.

On choisit les valeurs des résistances $R_0$ et $R_1$ de la manière suivante :

$$R_0 = \frac{1}{2\pi f_l (C_0-C_p)}$$

$$R_1 = \frac{1}{2\pi f_I C_0} = R_0 \left(1 - \frac{C_p}{C_0}\right)$$

de sorte qu'à la fréquence intermédiaire $f_I$, les fonctions de transfert A(f) et B(f) sont telles que $A(f_I)/B(f_I)=(1-j)/2=e^{-j\pi/4}/\sqrt{2}$ avec $B(f_I)=1/[2\pi f_I(C_0+jC_p)]$. En conséquence, la tension de sortie Y a, à la fréquence $f_I$, une composante $Y(f_I)$ proportionnelle à

$$A1(f_I)-A2(f_I)-B1(f_I)+B2(f_I)$$

$$= B(f_I).[X3(f_I).e^{-j\pi/4}/\sqrt{2} - X2(f_I)]$$

Les grilles des transistors 68-71 étant attaquées par le même signal VK, on obtient les valeurs différentes des résistances $R_0$ et $R_1$ indiquées ci-dessus en prévoyant pour les transistors PMOS 68, 71 un canal de même longueur mais de plus petite largeur que le canal des transistor PMOS 69, 70.

Le circuit représenté sur la figure 13 comporte encore des moyens pour équilibrer les tensions continues sur les entrées des amplificateurs différentiels 102, 103. Il est ainsi prévu deux transistors NMOS 108, 109 ayant leurs sources connectées à la masse, leurs grilles connectées à la tension VF et leurs drains respectivement reliés aux émetteurs des transistors npn 79, 80. Ces transistors injectent un courant constant i0 sur les émetteurs des transistors 79, 80 pour compenser le fait que la résistance $R_1$ des canaux des transistors PMOS 69, 70 est plus faible que la résistance des canaux des transistors PMOS 68, 71.

Les condensateurs 88-91 ont des capacités sensiblement plus faibles que celles des condensateurs 98 et 101. Ces condensateurs 88-91 servent, avec les impédances d'entrée (émetteurs) des transistors npn 78, 81, à filtrer des harmoniques à haute fréquence des signaux mélangés afin de ne pas perturber les entrées des amplificateurs différentiels 102, 103. La capacité des condensateurs 89, 90 est un peu plus élevée que celle des condensateurs 88, 91, pour tenir compte du fait que l'impédance d'entrée des transistors 79, 80 est plus faible que celle des transistors 78, 81.

Le circuit comprend par ailleurs un étage 110 de huit transistors npn 111-118 dont les émetteurs sont collectivement reliés au collecteur d'un autre transistor npn 120. La base du transistor 120 reçoit la tension continue de polarisation BS, et son émetteur est relié au drain d'un transistor NMOS 121 de caractéristiques identiques à celles des transistors 47, 49, dont la source est à la masse et la grille reçoit la tension VF. Les bases des transistors 111, 114 reçoivent l'onde C. Les bases des transistors 112, 113 reçoivent l'onde $\overline{C}$. Les bases des transistors 115, 118 reçoivent l'onde S. Les bases des transistors 116, 117 reçoivent l'onde $\overline{S}$. Les collecteurs des transistors 111, 113 sont reliés à l'émetteur du transistor npn 80, tandis que les collecteurs des transistors 112, 114 sont reliés à l'émetteur du transistor npn 79. Ceci compense le fait que les émetteurs des transistors 79, 80 sont reliés chacun à seulement deux transistors des cellules de Gilbert 12, 12', 14, 14' alors que les émetteurs des transistors 78, 81 sont reliés à quatre transistors des cellules de Gilbert 12, 12, 14, 14'. Deux autres transistors npn en montage cascode 76, 77, ayant leurs collecteurs et leurs bases à la tension d'alimentation positive VA, ont leurs émetteurs reliés aux collecteurs des transistors 63, 73, 83, 93, 115, 116, 117, 118 pour équilibrer le circuit.

Le filtrage haute fréquence opéré par les condensateurs 88-91 et l'injection des courants i0 et des courants issus de l'étage 110 n'ont pratiquement aucune influence au voisinage de la fréquence intermédiaire $f_I$, de sorte qu'ils n'affectent pas les impédances complexes $Z_A$ et $Z_B$ à la fréquence $f_I$.

On note que si on permute les ondes S et C (et $\overline{S}$ et $\overline{C}$) sur le schéma de la figure 13, ce qui est aisément réalisable au moyen de commutateurs placés entre l'oscillateur local et le dispositif mélangeur, alors le signal X1 est représenté par i3-i4 et le signal X2 par i1-i2. Avec une telle permutation, le dispositif de la figure 13 devient approprié pour une fréquence de communication de la forme $f_C=f_0-f_I$ (cf. figure 3).

Le fait d'utiliser des résistances variables telles que les canaux des transistors MOS 68-71 permet un asservissement de ces résistances pour compenser les éventuelles variations dues au procédé de fabrication ou à des paramètres extérieurs tels que la température ou les tensions d'alimentation.

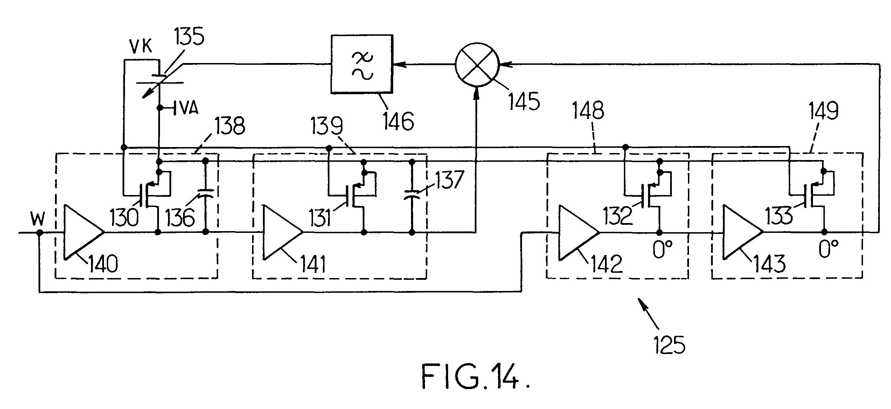

La figure 14 montre un circuit 125 d'asservissement de la tension VK de réglage des valeurs des résistances $R_0$ et $R_1$ des canaux des transistors PMOS 68-71. Ce circuit 125 comprend quatre transistors PMOS 130-133 ayant leurs sources à la tension d'alimentation VA, et leurs grilles à la tension VK délivrée par un générateur de tension variable 135. Les transistors 130 et 131, qui sont chacun montés en parallèle avec un condensateur respectif 136, 137, sont identiques aux transistors PMOS 68, 71 de résistance $R_0$, et les transistors 132 et 133 sont identiques aux transistors PMOS 69, 70 de résistance $R_1=R_0(1-C_p/C_0)$. Les drains des transistors 130-133 sont reliés chacun à la sortie d'un amplificateur à transconductance respectif 140-143. Les drains des transistors 130 et 132 sont en outre reliés aux entrées des amplificateurs à transconductance 141 et 143, respectivement. Le circuit d'asservissement 125 comprend ainsi deux filtres RC en cascade 138, 139, le premier composé de l'amplificateur à transconductance 140, du transistor 130 et du condensateur 136, et le second composé de l'amplificateur à transconductance 141, du transistor 131 et du condensateur 137, et d'autre part deux cellules passe-tout en cascade 148, 149, la première composée de l'amplificateur à transconductance 142 et du transistor 132, et la seconde composée de l'amplificateur à transconductance 143 et du transistor 133. Les entrées des amplificateurs à transconductance 140 et 142 reçoivent une onde sinusoïdale W de fréquence fixe $f_1$ proche de la fréquence intermédiaire $f_I$. Les drains des transistors 131 et 133 sont en outre reliés aux deux entrées d'un multiplieur 145. La sortie du multiplieur 145 est reliée à l'entrée d'un filtre passe-bas 146 ayant une fréquence de coupure sensiblement inférieure à $f_1$. Le signal de sortie du filtre 146 est adressé au générateur 135 pour fixer la valeur de la tension VK. Les amplificateurs à transconductance 140-143 peuvent être constitués par des cellules de Gilbert analogues aux cellules 12, 14 avec un étage de transistors npn montés en cascode de façon semblable aux transistors 78-81 afin de présenter sur les collecteurs de ces transistors npn une capacité parasite $C_p$ du même ordre.

Les condensateurs 136 et 137 sont dimensionnés pour que leur capacité soit $C'_0 = C_0 \cdot f_I / f_1$. Ainsi, les filtres RC en cascade 138 et 139 introduisent chacun à la fréquence $f_1$ un déphasage de $\Delta\varphi + \pi/4$ lorsque la tension VK est à la bonne valeur (celle pour laquelle $2\pi f_I R_0 (C_0 - C_p) = 1$ et $2\pi f_I R_1 C_0 = 1$), $\Delta\varphi$ représentant le déphasage qu'introduisent les cellules 148, 149. L'onde W étant de la forme $\sin 2\pi f_1 t$, les deux entrées du multiplieur 145 sont en quadrature lorsque la tension VK a la bonne valeur, de sorte que la sortie du multiplieur est à la fréquence $2f_1$ et que la commande du générateur variable 135 n'est pas modifiée du fait du filtrage passe-bas. Si en revanche la tension VK dévie de la bonne valeur, le multiplieur 145 délivre une composante continue qui, intégrée par le filtre 146, ramène la tension VK vers la bonne valeur.

La fréquence $f_1$ de fonctionnement du circuit d'asservissement 125 serait idéalement égale à la fréquence intermédiaire $f_I$. Mais comme on ne dispose pas nécessairement d'une onde sinusoïdale à la fréquence intermédiaire, on choisit une fréquence $f_1$ aisément disponible qui soit proche de $f_I$, en tenant compte de la différence dans la capacité $C'_0 = C_0 f_I / f_1$. Dans le cas d'une fréquence intermédiaire de 10,7 MHz, on peut par exemple utiliser une fréquence $f_1$ de 11,15 MHz si on dispose d'un quartz résonant à cette fréquence.

Dans le cas d'un dispositif mélangeur selon la figure 11, c'est-à-dire lorsqu'on peut considérer que les capacités parasites sont négligeables, il n'y a pas de différence entre les valeurs ohmiques des résistances 30 et 34 ($R_0 = R_1 = R$), et un circuit d'asservissement du même genre que celui de la figure 14 peut être utilisé pour asservir la valeur de R lorsque les résistances identiques 30, 34 sont des résistances variables. L'asservissement assure alors que $2\pi RC f_I = 1$ indépendamment des fluctuations extérieures.

## Revendications

1.  Dispositif mélangeur à réjection de fréquence image, comprenant des moyens de mélange (12, 14) pour former un premier signal (X1) par mélange d'un signal radio d'entrée (X) avec une première onde de fréquence $f_0$ fournie par un oscillateur local (10) et un second signal (X2) par mélange du signal radio d'entrée (X) avec une seconde onde de fréquence $f_0$ fournie par l'oscillateur local (10) et ayant un retard de phase de 90° par rapport à ladite première onde, et des moyens (18; 18a; 18b; 18c; 18d; 18e; 18f; 18g) de sommation algébrique de troisième et quatrième signaux mutuellement déphasés (X3', X4) obtenus à partir desdits premier et second signaux (X1, X2), pour produire un signal de sortie (Y) possédant, à une fréquence intermédiaire $f_I$, une phase représentative de la phase $(\varphi; \varphi')$ que possède le signal radio d'entrée à une fréquence de communication $f_C$ de la forme $f_0 - f_I$ ou $f_0 + f_I$, avec réjection de la phase $(\varphi'; \varphi)$ que possède le signal radio d'entrée à la fréquence image $2f_0 - f_C$, **caractérisé en ce qu'**il comprend en outre des moyens déphaseurs (24; 24a; 24b; 24c; 24d; 24e; 24f; 24g) produisant ledit troisième signal (X3') par filtrage d'une somme algébrique des premier et second signaux (X1, X2) avec une fonction de transfert A(f), et des moyens pour produire ledit quatrième signal (X4) en appliquant à l'un desdits premier et second signaux (X1, X2) une fonction de transfert B(f) telle que, à la fréquence intermédiaire $f_I$, le rapport $A(f_I)/B(f_I)$ soit de module $1/\sqrt{2}$ et d'argument $\pm 45°$ ou $\pm 135°$.

2.  Dispositif selon la revendication 1, **caractérisé en ce que**, la fréquence de communication $f_C$ étant égale à $f_0 - f_I$, les moyens de sommation algébrique (18; 18a; 18b; 18c) et les moyens déphaseurs (24; 24a; 24b; 24c) sont agencés pour produire un signal de sortie (Y) qui, à la fréquence intermédiaire $f_I$, est la partie réelle d'un signal complexe proportionnel à $(X1 + X2)e^{-j\pi/4}/\sqrt{2} - X1$, à $(X2 - X1)e^{j\pi/4}/\sqrt{2} + X1$, à $(X1 + X2)e^{j\pi/4}/\sqrt{2} - X2$ ou à $(X2 - X1)e^{-j\pi/4}/\sqrt{2} - X2$, X1 et X2 désignant respectivement lesdits premier et second signaux.

3.  Dispositif selon la revendication 1, **caractérisé en ce que**, la fréquence de communication $f_C$ étant égale à $f_0 + f_I$, les moyens de sommation algébrique (18d; 18e; 18f; 18g) et les moyens déphaseurs (24d; 24e; 24f; 24g) sont agencés pour produire un signal de sortie (Y) qui, à la fréquence intermédiaire $f_I$, est la partie réelle d'un signal complexe proportionnel à $(X1 + X2)e^{-j\pi/4}/\sqrt{2} - X2$, à $(X1 - X2)e^{j\pi/4}/\sqrt{2} + X2$, à $(X1 + X2)e^{j\pi/4}/\sqrt{2} - X1$ ou à $(X1 - X2)e^{-j\pi/4}/\sqrt{2} - X1$, X1 et X2 désignant respectivement lesdits premier et second signaux.

4.  Dispositif selon l'une quelconque des revendications 1 à 3, **caractérisé en ce que** les moyens déphaseurs comprennent au moins un filtre RC (24) sans capacité flottante.

**5.** Dispositif selon la revendication 4, **caractérisé en ce que** le filtre RC (24) comprend une première résistance (30) et un condensateur (32) connectés en parallèle entre une première borne à laquelle est appliquée une tension constante et une seconde borne, et en ce que deux courants (I01, I90) représentant respectivement lesdits premier et second signaux (X1, X2) sont injectés à ladite seconde borne, la tension (V1) présente à ladite seconde borne constituant ledit troisième signal (X3') fourni aux moyens de sommation algébrique (18).

**6.** Dispositif selon la revendication 5, **caractérisé en ce qu'**il comprend une seconde résistance (34) de valeur ohmique sensiblement égale à celle de ladite première résistance (30), connectée entre ladite première borne et une troisième borne, et en ce qu'un courant (I02) représentant ledit premier signal (X1) ou ledit second signal (X2) est injecté à ladite troisième borne, la tension (V2) présente à ladite troisième borne constituant ledit quatrième signal (X4) fourni aux moyens de sommation algébrique (18).

**7.** Dispositif selon la revendication 6, **caractérisé en ce que** les première et seconde résistances (30, 34) sont des résistances variables sensiblement identiques dont la valeur ohmique R est asservie pour vérifier la relation $2\pi RCf_I=1$, où C est la capacité dudit condensateur (32).

**8.** Dispositif selon la revendication 7, **caractérisé en ce qu'**il comprend un circuit (125) d'asservissement desdites résistances variables (30, 32) comprenant deux filtres RC en cascade (138, 139) comportant chacun un condensateur (136, 137) de capacité C. $f_I/f_1$ en parallèle avec une résistance variable (130, 131) sensiblement identique auxdites première et seconde résistances, une onde sinusoïdale de fréquence $f_1$ du même ordre que la fréquence intermédiaire $f_I$ étant appliquée aux deux filtres RC en cascade, le circuit d'asservissement comportant en outre un multiplieur (145) recevant d'une part ladite onde déphasée par les filtres RC en cascade et d'autre part une version non déphasée de ladite onde, et un filtre passe-bas (146) recevant le signal de sortie du multiplieur et dont la sortie règle la valeur ohmique desdites résistances variables.

**9.** Dispositif selon la revendication 4, **caractérisé en ce que** les moyens de mélange comprennent une première cellule de Gilbert (12) délivrant des premier et second courants (i1, i2) dont la différence représente le premier signal (X1), et une seconde cellule de Gilbert (14) délivrant des troisième et quatrième courants (i3, i4) dont la différence représente le second signal (X2), en ce que les moyens déphaseurs comprennent des première et seconde résistances sensiblement identiques (68, 71) et des premier et second condensateurs sensiblement identiques (98, 101), la première résistance (68) et le premier condensateur (98) étant montés en parallèle entre une première borne à laquelle est appliquée une tension constante (VA) et une seconde borne, et la seconde résistance (71) et le second condensateur (101) étant montés en parallèle entre ladite première borne et une troisième borne, en ce que les premier et troisième courants (i1, i3) sont injectés à ladite seconde borne, tandis que les second et quatrième courants (i2, i4) sont injectés à ladite troisième borne, la différence entre la tension (A1) présente à la troisième borne et la tension (A2) présente à la seconde borne représentant ledit troisième signal (X3'), en ce que le dispositif comporte en outre des troisième et quatrième résistances (69, 70) sensiblement identiques, la troisième résistance (69) étant montée entre ladite première borne et une quatrième borne, et la quatrième résistance (70) étant montée entre ladite première borne et une cinquième borne, et en ce que les premier et second courants (i1, i2) ou les troisième et quatrième courants (i3, i4) sont respectivement injectés à ladite quatrième borne et à ladite cinquième borne, la différence entre la tension (B1) présente à la cinquième borne et la tension (B2) présente à la quatrième borne représentant ledit quatrième signal (X4).

**10.** Dispositif selon la revendication 9, **caractérisé en ce qu'**il comprend des premier, second, troisième et quatrième transistors bipolaires (78,81,79,80) dont les bases sont à une tension constante (VA), les premier et troisième courants (i1, i3) étant injectés à la seconde borne par l'intermédiaire du premier transistor bipolaire (78), les second et quatrième courants (i2, i4) étant injectés à la troisième borne par l'intermédiaire du second transistor bipolaire (81), le premier courant (i1) ou le troisième courant (i3) étant injecté à la quatrième borne par l'intermédiaire du troisième transistor bipolaire (79), et le second courant (i2) ou le quatrième courant (i4) étant injecté à ladite cinquième borne par l'intermédiaire du quatrième transistor bipolaire (80).

**11.** Dispositif selon la revendication 10, **caractérisé en ce que** les première, seconde, troisième et quatrième résistances (68,71,69,70) sont dimensionnées de façon que le rapport entre la. valeur ohmique ($R_1$) des troisième et quatrième résistances (68, 71) et la valeur ohmique ($R_0$) des première et seconde résistances (69, 70) soit de $1-C_p/C_0$, où $C_0$ désigne la capacité des premier et second condensateurs (98, 101), et $C_p$ désigne une capacité parasite présente entre la première borne et chacune des seconde, troisième, quatrième et cinquième borne du fait des transistors bipolaires (78-81).

**12.** Dispositif selon la revendication 11, **caractérisé en ce que** les première, seconde, troisième et quatrième résistance sont des résistances variables (68-71) asservies pour que la valeur ohmique des première et seconde résistances soit $R_0=1/[2\pi(C_0-C_p)f_I]$ et que la valeur ohmique des troisième et quatrième résistances soit $R_1=1/(2\pi C_0 f_I)$.

**13.** Dispositif selon la revendication 12, **caractérisé en ce que** lesdites résistances variables sont constituées par les canaux de transistors MOS (68-71) dont les grilles respectives reçoivent une tension de réglage (VK).

**14.** Dispositif selon la revendication 12 ou 13, **caractérisé en ce qu'**il comprend un circuit (125) d'asservissement desdites résistances variables (68-71), comprenant deux filtres RC en cascade (138, 139) comportant chacun un condensateur (136, 137) de capacité $C_0.f_I/f_1$ en parallèle avec une résistance variable (130, 131) sensiblement identique auxdites première et seconde résistances variables (68, 71) entre ladite première borne et une sortie dudit filtre RC, une onde sinusoïdale (W) de fréquence $f_1$ du même ordre que la fréquence intermédiaire $f_I$ étant appliquée aux deux filtres RC en cascade, le circuit d'asservissement (125) comprenant en outre deux cellules comportant chacune une résistance variable (132, 133) sensiblement identique auxdites troisième et quatrième résistances variables (69, 70) connectée entre ladite première borne et une sortie de ladite cellule, l'onde (W) de fréquence $f_1$ étant également appliquée aux deux cellules en cascade, et en ce que le circuit d'asservissement (125) comprend un multiplieur (145) recevant deux signaux respectivement issus des filtres RC en cascade et des cellules en cascade, et un filtre passe-bas (146) dont l'entrée est reliée à la sortie du multiplieur (145) et dont la sortie commande les valeurs ohmiques des première, seconde, troisième et quatrième résistances variables (68-71) et des résistances variables (130-133) du circuit d'asservissement.

**15.** Dispositif selon l'une quelconque des revendications 10 à 14, **caractérisé en ce que** les premier, second, troisième et quatrième transistors bipolaires (78,81,79,80) sont des transistors npn dont les collecteurs sont respectivement reliés auxdites seconde, troisième, quatrième et cinquième bornes et dont les émetteurs sont reliés à ladite première borne par l'intermédiaire de condensateurs de filtrage respectifs (88,91,89,90) de capacités sensiblement plus faibles que celle desdits premier et second condensateurs (98,101).

**Patentansprüche**

**1.** Mischereinrichtung mit Beseitigung der Spiegelfrequenz, welche Mischeinrichtungen (12, 14) aufweist zur Bildung eines ersten Signals (X1) durch Mischen eines Eingangsfunksignals (X) mit einer ersten Welle der Frequenz $f_0$, welche von einem lokalen Schwingungsgenerator (10) abgegeben wird, und eines zweiten Signals (X2) durch Mischen des Eingangsfunksignals (X) mit einer zweiten Welle der Frequenz $f_0$, die von dem lokalen Schwingungsgenerator abgegeben wird und gegenüber der ersten Welle um 90° phasenverzögert ist, sowie Einrichtungen (18; 18a,; 18b; 18c; 18d; 18e; 18f; 18g) zur algebraischen Summierung eines dritten und vierten Signals, welche zueinander phasenversetzt (X3', X4) sind und aus dem ersten und zweiten Signal (X1, X2) zur Erzeugung eines Ausgangssignals (Y) erhalten werden, welches bei einer Mittelfrequenz F1 eine Phase aufweist, die repräsentativ für die Phase ($\varphi$; $\varphi'$) ist, welche das Eingangsfunksignal bei einer Kommunikationsfrequenz $f_C$ in der Form $f_0-F_I$ bzw. $f_0+f_I$ unter Beseitigung der Phase ($\varphi$; $\varphi'$) aufweist, die das Eingangsfunksignal bei der Spiegelfrequenz $2f_0-f_C$ aufweist, **dadurch gekennzeichnet**, dass sie des weiteren Phasenschiebereinrichtungen (24; 24a; 24b; 24c; 24d; 24e; 24f; 24g) umfasst, welche das dritte Signal (X3') durch Filtern einer algebraischen Summe aus dem ersten und zweiten Signal (X1, X2) mit einer Transferfunktion A(f) erzeugt, sowie Einrichtungen zum Erzeugen des vierten Signals (X4) unter Anwendung einer Transferfunktion B(f) auf das erste oder zweite Signal (X1, X2) in der Weise, dass bei der Mittelfrequenz $f_I$ das Verhältnis $A(f_I) / B(f_I)$ das Modul 1/2 und das Argument $\pm 45°$ bzw. $\pm 135°$ besitzt.

**2.** Einrichtung nach Anspruch 1, **dadurch gekennzeichnet**, dass dann, wenn die Kommunikationsfrequenz fc gleich $f_0-f_I$ ist, die Einrichtungen (18; 18a; 18b; 18c) zur algebraischen Aufsummierung und die Phasenschiebereinrichtungen (24; 24a; 24b; 24c) so angeordnet sind, dass sie ein Ausgangssignal (Y) erzeugen, das bei der Mittelfrequenz $f_I$ den realen Anteil eines komplexen Signals darstellt, welches proportional zu $(X1+X2)e^{-j\pi/4} / 2-X1$, zu $(X1-X2)e^{j\pi/4}/ 2+X1$, zu $(X1+X2)e^{j\pi/4}/ 2-X2$ oder zu $(X1-X2)e^{-j\pi/4}/ 2-X2$ ist, wobei X1 und X2 jeweils das erste und zweite Signal bezeichnen.

**3.** Einrichtung nach Anspruch 1, **dadurch gekennzeichnet**, dass dann, wenn die Kommunikationsfrequenz $f_C$ gleich $f_0+f_I$ ist, die Einrichtungen (18d; 18e 18f; 18g) zur algebraischen Aufsummierung und die Phasenschiebereinrichtungen (24d; 24e; 24f; 24g) so angeordnet sind, dass sie ein Ausgangssignal (Y) erzeugen, das bei der Mittelfrequenz $f_I$ den realen Anteil eines komplexen Signals darstellt, welches proportional zu (X1+X2)e$^{-j\pi/4}$ / 2-X2, zu (X1-X2)e$^{j\pi/4}$/ 2+X2, zu (X1+X2)e$^{j\pi/4}$/ 2-X1 oder zu (X1-X2)e$^{-j\pi/4}$/ 2-X1 ist, wobei X1 und X2 jeweils das erste und zweite Signal bezeichnen.

4. Einrichtung nach einem der Ansprüche 1 bis 3, **dadurch gekennzeichnet**, dass die Phasenschiebereinrichtungen mindestens ein RC-Filter (24) ohne Kapazitätsschwankungen aufweist.

5. Einrichtung nach Anspruch 4, **dadurch gekennzeichnet**, dass das RC-Filter (24) einen ersten Widerstand (30) und einen Kondensator (32) aufweist, welche parallel zueinander zwischen einem ersten Anschluss, an welchem eine konstante Spannung anliegt, und einem zweiten Anschluss geschaltet sind, und dass zwei Ströme (I01, I90), welche jeweils das erste und zweite Signal (X1, X2) repräsentieren, in den zweiten Anschluss direkt eingeleitet werden, wobei die am zweiten Anschluss vorhandene Spannung (V1) das dritte Signal (X3') bildet, welches an die Einrichtung (18) zur algebraischen Aufsummierung abgegeben wird.

6. Einrichtung nach Anspruch 5, **dadurch gekennzeichnet**, dass sie einen zweiten Widerstand (34) aufweist, dessen Widerstandswert im wesentlichen gleich dem des ersten Widerstands (30) ist, der zwischen den ersten Anschluss und einen dritten Anschluss geschaltet ist, und dass ein Strom (102), welcher das erste Signal (X1) oder das zweite Signal (X2) repräsentiert, direkt in den dritten Anschluss eingeleitet wird, wobei die an dem dritten Anschluss vorhandene Spannung (V2) das vierte Signal (X4) bildet, welches an die Einrichtung zur algebraischen Aufsummierung (18) abgegeben wird.

7. Einrichtung nach Anspruch 6, **dadurch gekennzeichnet**, dass der erste und zweite Widerstand (30, 34) im wesentlichen identische variable Widerstände sind, deren Widerstandswert R so geregelt ist, dass die Beziehung $2\pi RCf_l=1$ nachprüfbar ist, wobei C die Kapazität des Kondensators (32) darstellt.

8. Einrichtung nach Anspruch 7, **dadurch gekennzeichnet**, dass sie eine Schaltung (125) zum Regeln der variablen Widerstände (30, 32) aufweist, welche zwei RC-Filter (136, 137) in Kaskadenanordnung besitzen, von denen jedes einen Kondensator (136, 137) mit der Kapazität $Cf_l/f_1$ parallel zu einem variablen Widerstand (130, 131) aufweist, der im wesentlichen identisch mit dem ersten und zweiten Widerstand ist, wobei eine Sinuswelle der Frequenz $f_1$ in derselben Größenordnung wie die Mittelfrequenz $f_l$ an die beiden RC-Filter in Kaskadenanordnung angelegt ist, wobei die Regelschaltung des weiteren ein Multiplikatorelement (145) aufweist, welches zum einen die durch die RC-Filter in Kaskadenanordnung phasenverschobene Welle und zum anderen eine nicht-phasenverschobene Version der Welle empfängt, und wobei ein Tiefpassfilter (146) das Ausgangssignal des Multiplikatorelements empfängt, dessen Ausgang den Widerstandwert der variablen Widerstände regelt.

9. Einrichtung nach Anspruch 4, **dadurch gekennzeichnet**, dass die Mischeinrichtungen eine erste Gilbertzelle (12), welche einen ersten und einen zweiten Strom (i1, i2) abgibt, wobei die Differenz zwischen diesen das erste Signal (X1) repräsentiert, und eine zweite Gilbertzelle (14) aufweisen, welche den dritten und vierten Strom (i3, i4) abgibt, wobei die Differenz zwischen diesen das zweite Signal (X2) repräsentiert; dass die Phasenschiebereinrichtungen einen ersten und einen im wesentlichen hierzu identischen zweiten Widerstand (68, 71) sowie einen ersten Kondensator und einen hierzu im wesentlichen identischen Kondensator (98, 101) aufweisen, wobei der erste Widerstand (68) und der zweite Kondensator (98) zwischen einen ersten Anschluss, an den eine konstante Spannung (VA) angelegt ist, und einen zweiten Anschluss parallel zueinander geschaltet sind und wobei der zweite Widerstand (71) und der zweite Kondensator (101) zwischen den ersten Anschluss und einen dritten Anschluss parallel zueinander geschaltet sind; dass der erste und der dritte Strom (il, i8) direkt in den zweiten Anschluss eingeleitet werden, wohingegen der zweite und der vierte Strom (i2, i4) direkt in den dritten Anschluss eingeleitet werden, wobei die Differenz zwischen der am dritten Anschluss anliegenden Spannung (A1) und der am zweiten Anschluss anliegenden Spannung (A2) das dritte Signal (X3') repräsentiert; dass die Einrichtung des weiteren einen dritten und einen hierzu im wesentlichen identischen vierten Widerstand (69, 70) aufweist, wobei der dritte Widerstand (69) zwischen den ersten Anschluss und einen vierten Anschluss geschaltet ist und der vierte Widerstand (70) zwischen den ersten Anschluss und einen fünften Anschluss geschaltet ist; und dass der erste und zweite Strom (i1, i2) bzw. der dritte und vierte Strom (i3, i4) jeweils direkt in den vierten Anschluss und den fünften Anschluss eingeleitet wird, wobei die Differenz zwischen der am fünften Anschluss anliegenden Spannung (B1) und der am vierten Anschluss anliegenden Spannung (B2) das vierte Signal (X4) repräsentiert.

10. Einrichtung nach Anspruch 9, **dadurch gekennzeichnet**, dass sie einen ersten, zweite, dritten und vierten bipolaren Transistor (78, 81, 79, 80) aufweist, wobei die jeweilige Basis der Transistoren eine konstante Spannung (VA) aufweist, wobei der erste und dritte Strom (i1, i3) mittels des ersten bipolaren Transistors (78) direkt in den zweiten Anschluss eingeleitet wird, wobei der zweite und vierte Strom (i2, i4) mittels des zweiten bipolaren Transistors (81) direkt in den dritten Anschluss eingeleitet wird, wobei der erste Strom (i1) oder der dritte Strom (i3) mittels des dritten bipolaren Transistors (79) direkt in den vierten Anschluss eingeleitet wird, und wobei der zweite Strom (i2) oder der vierte Strom (i4) mittels des vierten bipolaren Transistors (80) direkt in den fünften Anschluss eingeleitet wird.

11. Einrichtung nach Anspruch 10, **dadurch gekennzeichnet**, dass der erste, zweite, dritte und vierte Widerstand (68, 71, 69, 70) in der Weise dimensioniert sind, dass das Verhältnis zwischen dem Widerstandswert ($R_1$) des dritten und vierten Widerstands (68, 71) und der Widerstandwert ($R_0$) des ersten und zweiten Widerstands (69, 70) $1-C_p/C_0$ beträgt, wobei $C_0$ die Kapazität des ersten und zweiten Kondensators (98, 101) und $C_p$ eine zwischen dem ersten Anschluss und jedem der Anschlüsse vom zweiten bis zum fünften Anschluss aufgrund der bipolaren Transistoren (78 - 81) vorhandene parasitäre Kapazität bezeichnet.

12. Einrichtung nach Anspruch 11, **dadurch gekennzeichnet**, dass der erste, zweite, dritte und vierte Widerstand variable Widerstände (68 - 71) sind, welche so geregelt sind, dass der Widerstandswert des ersten und zweiten Widerstands $R0 = 1 / [2\pi (C_0 - C_p)f_I]$ beträgt und der Widerstandswert des dritten und vierten Widerstands $R1 = 1 / 2\pi C_0 f_I)$ beträgt.

13. Einrichtung nach Anspruch 12, **dadurch gekennzeichnet**, dass die variablen Widerstände aus Transistorkanälen in MOS-Technik (68 - 71) bestehen, deren jeweilige Gitter eine Regelspannung (VK) erhalten.

14. Einrichtung nach Anspruch 12 oder 13, **dadurch gekennzeichnet**, dass sie eine Schaltung (125) zum Regeln der variablen Widerstände (68 - 71) aufweist, welche zwei RC-Filter (138, 139) in Kaskadenanordnung besitzen, von denen jedes einen Kondensator (136, 137) mit der Kapazität $C_0 f_I/f_1$ parallel zu einem variablen Widerstand (130, 131) aufweist, der im wesentlichen identisch mit dem ersten und zweiten variablen Widerstand (68, 71) zwischen dem ersten Anschluss und einen Ausgang des RC-Filters ist, wobei eine Sinuswelle (W) der Frequenz $f_1$ in derselben Größenordnung wie die Mittelfrequenz $f_I$ an die beiden RC-Filter in Kaskadenanordnung angelegt ist, wobei die Regelschaltung (125) des weiteren zwei Zellen umfasst, welche jeweils einen variablen Widerstand (132, 133) aufweisen, der im wesentlichen identisch mit dem dritten und vierten variablen Widerstand (69, 70) und zwischen den ersten Anschluss und einen Ausgang der Zelle geschaltet ist, wobei die Welle (W) mit der Frequenz $f_1$ auch an die beiden in Kaskade geschalteten Zellen angelegt ist, und dass die Regelschaltung (125) ein Multiplikatorelement (145) aufweist, welches zwei jeweils von den RC-Filtern in Kaskadenanordnung und den in Kaskade angeordneten Zellen abgegebene Signale empfängt, sowie ein Tiefpassfilter (146), dessen Eingang mit dem Ausgang des Multiplikatorelements (145) verbunden ist und dessen Ausgang die Widerstandswerte des ersten, zweiten, dritten und vierten variablen Widerstands (68 - 71) und der variablen Widerstände (130 - 133) der Regelschaltung regelt.

15. Einrichtung nach einem der Ansprüche 10 bis 14, **dadurch gekennzeichnet**, das der erste, zweite, dritte und vierte bipolare Transistor (78, 81, 79, 80) npn-Transistoren sind, deren Kollektor jeweils mit dem zweiten, dritten, vierten und fünften Anschluss verbunden ist und deren Emitter jeweils mittels eines jeweiligen Filterkondensators (88, 91, 89, 90), dessen Kapazität im wesentlichen schwächer ist als die Kapazität des ersten und zweiten Kondensators (98, 101), mit dem ersten Anschluss verbunden ist.

## Claims

1. Mixer device with image frequency rejection, comprising mixing means (12, 14) for forming a first signal (X1) by mixing an input radio signal (X) with a first wave of frequency $f_0$ delivered by a local oscillator (10) and a second signal (X2) by mixing the input radio signal (X) with a second wave of frequency $f_0$ delivered by the local oscillator (10) and having a phase lag of 90° with respect to said first wave, and means (18; 18a; 18b; 18c; 18d; 18e; 18f; 18g) of algebraic summation of third and fourth mutually phase-shifted signals (X3', X4) obtained from said first and second signals (X1, X2), in order to produce an output signal (Y) possessing, at an intermediate frequency $f_I$, a phase representative of the phase ($\phi$; $\phi'$) possessed by the input radio signal at a communication frequency $f_C$ of the form $f_0-f_I$ or $f_0+f_I$, with rejection of the phase ($\phi'$, $\phi$) possessed by the input radio signal at the image frequency $2f_0-f_C$, **characterized in that** it further comprises phase-shifter means (24; 24a; 24b; 24c; 24d; 24e; 24f; 24g) producing said third signal (X3') by filtering an algebraic sum of the first and second signals (X1, X2) with a transfer function A(f), and means for producing said fourth signal (X4) by applying to one of said first and second signals (X1, X2) a transfer function B(f) such that, at the intermediate frequency $f_I$, the ratio $A(f_I)/B(f_I)$ has modulus $1/\sqrt{2}$ and ar-

gument ±45° or ±135°.

2. Device according to Claim 1, **characterized in that**, with the communication frequency $f_C$ being equal to $f_0-f_I$, the means of algebraic summation (18; 18a; 18b; 18c) and the phase-shifter means (24; 24a; 24b; 24c) are arranged so as to produce an output signal (Y) which, at the intermediate frequency $f_I$, is the real part of a complex signal proportional to $(X1+X2)e^{-j\pi/4}/\sqrt{2}-X1$, to $(X2-X1)e^{j\pi/4}/\sqrt{2}+X1$, to $(X1+X2)e^{j\pi/4}/\sqrt{2}-X2$ or to $(X2-X1)e^{-j\pi/4}/\sqrt{2}-X2$, X1 and X2 respectively denoting said first and second signals.

3. Device according to Claim 1, **characterized in that**, with the communication frequency $f_C$ being equal to $f_0+f_I$, the means of algebraic summation (18d; 18e; 18f; 18g) and the phase-shifter means (24d; 24e; 24f; 24g) are arranged so as to produce an output signal (Y) which, at the intermediate frequency $f_I$, is the real part of a complex signal proportional to $(X1+X2)e^{-j\pi/4}/\sqrt{2}-X2$, to $(X1-X2)e^{j\pi/4}/\sqrt{2}+X2$, to $(X1+X2)e^{j\pi/4}/\sqrt{2}-X1$ or to $(X1-X2)e^{-j\pi/4}/\sqrt{2}-X1$, X1 and X2 respectively denoting said first and second signals.

4. Device according to any one of Claims 1 to 3, **characterized in that** the phase-shifter means comprise at least one RC filter (24) without floating capacitance.

5. Device according to Claim 4, **characterized in that** the RC filter (24) comprises a first resistor (30) and a capacitor (32) which are connected in parallel between a first terminal to which a constant voltage is applied and a second terminal, and in that two currents (I01, I90) respectively representing said first and second signals (X1, X2) are injected at said second terminal, the voltage (V1) present at said second terminal constituting said third signal (X3') delivered to the means of algebraic summation (18).

6. Device according to Claim 5, **characterized in that** it comprises a second resistor (34) with ohmic value substantially equal to that of said first resistor (30), connected between said first terminal and a third terminal, and in that a current (I02) representing said first signal (X1) or said second signal (X2) is injected at said third terminal, the voltage (V2) present at said third terminal constituting said fourth signal (X4) delivered to the means of algebraic summation (18).

7. Device according to Claim 6, **characterized in that** the first and second resistors (30, 34) are substantially identical variable resistors whose ohmic value R is slaved so as to satisfy the relation $2\pi RCf_I=1$,

where C is the capacitance of said capacitor (32).

8. Device according to Claim 7, **characterized in that** it comprises a circuit (125) for slaving said variable resistors (30, 32) comprising two cascaded RC filters (138, 139), each including a capacitor (136, 137) of capacitance $C.f_I/f_1$ in parallel with a variable resistor (130, 131) which is substantially identical to said first and second resistors, a sinusoidal wave of frequency $f_1$ of the same order as the intermediate frequency $f_I$ being applied to the two cascaded RC filters, the slaving circuit further including a multiplier (145) receiving, on the one hand, said wave phase-shifted by the cascaded RC filters and, on the other hand, a non-phase-shifted version of said wave, and a low-pass filter (146) receiving the output signal from the multiplier and whose output adjusts the ohmic value of said variable resistors.

9. Device according to Claim 4, **characterized in that** the mixing means comprise a first Gilbert cell (12) yielding first and second currents (i1, i2) whose difference represents the first signal (X1), and a second Gilbert cell (14) yielding third and fourth currents (i3, i4) whose difference represents the second signal (X2), in that the phase-shifter means comprise first and second substantially identical resistors (68, 71) and first and second substantially identical capacitors (98, 101), the first resistor (68) and the first capacitor (98) being mounted in parallel between a first terminal, to which a constant voltage (VA) is applied, and a second terminal, and the second resistor (71) and the second capacitor (101) being mounted in parallel between said first terminal and a third terminal, in that the first and third currents (i1, i3) are injected at said second terminal, whilst the second and fourth currents (i2, i4) are injected at said third terminal, the difference between the voltage (A1) present at the third terminal and the voltage (A2) present at the second terminal representing said third signal (X3'), in that the device further includes third and fourth substantially identical resistors (69, 70), the third resistor (69) being mounted between said first terminal and a fourth terminal, and the fourth resistor (70) being mounted between said first terminal and a fifth terminal, and in that the first and second currents (i1, i2) or the third and fourth currents (i3, i4) are respectively injected at said fourth terminal and at said fifth terminal, the difference between the voltage (B1) present at the fifth terminal and the voltage (B2) present at the fourth terminal representing said fourth signal (X4).

10. Device according to Claim 9, **characterized in that** it comprises first, second, third and fourth bipolar transistors (78, 81, 79, 80) whose bases are at a constant voltage (VA), the first and third currents (iI,

i3) being injected at the second terminal by way of the first bipolar transistor (78), the second and fourth currents (i2, i4) being injected at the third terminal by way of the second bipolar transistor (81), the first current (i1) or the third current (i3) being injected at the fourth terminal by way of the third bipolar transistor (79), and the second current (i2) or the fourth current (i4) being injected at said fifth terminal by way of the fourth bipolar transistor (80).

11. Device according to Claim 10, **characterized in that** the first, second, third and fourth resistors (68, 71, 69, 70) are sized in such a way that the ratio between the ohmic value ($R_1$) of the third and fourth resistors (68, 71) and the ohmic value ($R_0$) of the first and second resistors (69, 70) is $1-C_p/C_0$, where $C_0$ denotes the capacitance of the first and second capacitors (98, 101), and $C_p$ denotes a stray capacitance present between the first terminal and each of the second, third, fourth and fifth terminals due to the bipolar transistors (78-81).

12. Device according to Claim 11, **characterized in that** the first, second, third and fourth resistors are variable resistors (68-71) slaved so that the ohmic value of the first and second resistors is $R_0=1/[2\pi(C_0-C_p)f_l]$ and that the ohmic value of the third and fourth resistors is $R_1=1/(2\pi C_0 f_l)$.

13. Device according to Claim 12, **characterized in that** the said variable resistors consist of the channels of MOS transistors (68-71) whose respective gates receive an adjustment voltage (VK).

14. Device according to Claim 12 or 13, **characterized in that** it comprises a circuit (125) for slaving said variable resistors (68-71) comprising two cascaded RC filters (138, 139), each including a capacitor (136, 137) of capacitance $C_0.f_l/f_1$ in parallel with a variable resistor (130, 131) which is substantially identical to said first and second variable resistors (68, 71) between said first terminal and an output of said RC filter, a sinusoidal wave (W) of frequency $f_1$ of the same order as the intermediate frequency $f_l$ being applied to the two cascaded RC filters, the slaving circuit (125) further including two cells each including a variable resistor (132, 133) which is substantially identical to said third and fourth variable resistors (69, 70) and is connected between said first terminal and an output of said cell, the wave (W) of frequency $f_1$ being also applied to the two cascaded cells, and in that the slaving circuit (125) comprises a multiplier (145) receiving two signals arising respectively from the cascaded RC filters and from the cascaded cells, and a low-pass filter (146) whose input is linked to the output of the multiplier (145) and whose output controls the ohmic values of the first, second, third and fourth variable resistors (68-71) and of the variable resistors (130-133) of the slaving circuit.

15. Device according to any one of Claims 10 to 14, **characterized in that** the first, second, third and fourth bipolar transistors (78, 81, 79, 80) are npn transistors whose collectors are linked respectively to said second, third, fourth and fifth terminals and whose emitters are linked to said first terminal by way of respective filtering capacitors (88, 91, 89, 90) of substantially smaller capacitances than that of said first and second capacitors (98, 101).

FIG.1.

FIG.2.

EP 0 779 704 B1

## FIG.3.

$$\sin(\omega_I t - \varphi + 180°)$$
$$\sin(\omega_I t + \varphi')$$

12

X1

X4

$$\sin[(\omega_0 - \omega_I)t + \varphi]$$
$$\sin[(\omega_0 + \omega_I)t + \varphi']$$

X

$2 \cos \omega_0 t$

10 — O.L.

$2 \sin \omega_0 t$

14

X2

$$\sin(\omega_I t - \varphi + 90°)$$
$$\sin(\omega_I t + \varphi' + 90°)$$

22 +

X3

$$\sqrt{2} \sin(\omega_I t - \varphi + 135°)$$
$$\sqrt{2} \sin(\omega_I t + \varphi' + 45°)$$

24 −45°

X3′

$$\sin(\omega_I t - \varphi + 90°)$$
$$\sin(\omega_I t + \varphi')$$

18 − +

Y

$$\sqrt{2} \sin(\omega_I t - \varphi + 45°)$$

20

## FIG.4.

$$\sin(\omega_I t - \varphi + 180°)$$
$$\sin(\omega_I t + \varphi')$$

12

X1

X4

$$\sin[(\omega_0 - \omega_I)t + \varphi]$$
$$\sin[(\omega_0 + \omega_I)t + \varphi']$$

X

$2 \cos \omega_0 t$

10 — O.L.

$2 \sin \omega_0 t$

14

X2

$$\sin(\omega_I t - \varphi + 90°)$$
$$\sin(\omega_I t + \varphi' + 90°)$$

22a − +

X3

$$\sqrt{2} \sin(\omega_I t - \varphi + 45°)$$
$$\sqrt{2} \sin(\omega_I t + \varphi' + 135°)$$

24a +45°

X3′

$$\sin(\omega_I t - \varphi + 90°)$$
$$\sin(\omega_I t + \varphi' + 180°)$$

18a + +

Y

$$\sqrt{2} \sin(\omega_I t - \varphi + 135°)$$

20

FIG.5.

FIG.6.

FIG.7.

$$\sin\left[(\omega_0-\omega_I)t+\varphi\right]$$
$$\sin\left[(\omega_0+\omega_I)t+\varphi'\right]$$
$X$

12

$\sin(\omega_I t-\varphi+180°)$
$\sin(\omega_I t+\varphi')$

X1

$2\cos\omega_0 t$

10

O.L.

$2\sin\omega_0 t$

X2

14

$\sin(\omega_I t-\varphi+90°)$
$\sin(\omega_I t+\varphi'+90°)$

$\sqrt{2}\sin(\omega_I t-\varphi+135°)$
$\sqrt{2}\sin(\omega_I t+\varphi'+45°)$

X 3

22d

$-45°$

24d

$\sin(\omega_I t-\varphi+90°)$
$\sin(\omega_I t+\varphi')$

X 3'

X 4

18d

Y

$\sqrt{2}\sin(\omega_I t+\varphi'-45°)$

20

FIG.8.

$$\sin\left[(\omega_0-\omega_I)t+\varphi\right]$$
$$\sin\left[(\omega_0+\omega_I)t+\varphi'\right]$$
$X$

12

$\sin(\omega_I t-\varphi+180°)$
$\sin(\omega_I t+\varphi')$

X1

$2\cos\omega_0 t$

10

O.L.

$2\sin\omega_0 t$

X2

14

$\sin(\omega_I t-\varphi+90°)$
$\sin(\omega_I t+\varphi'+90°)$

$\sqrt{2}\sin(\omega_I t-\varphi-135°)$
$\sqrt{2}\sin(\omega_I t+\varphi'-45°)$

X 3

22e

$+45°$

24e

$\sin(\omega_I t-\varphi-90°)$
$\sin(\omega_I t+\varphi')$

X 3'

X 4

18e

Y

$\sqrt{2}\sin(\omega_I t+\varphi'+45°)$

20

FIG.9.

$$x$$

$$\sin[(\omega_0-\omega_I)t+\varphi]$$
$$\sin[(\omega_0+\omega_I)t+\varphi']$$

12

$$2\cos\omega_0 t$$

10 — O.L.

$$2\sin\omega_0 t$$

14

X1 — $\sin(\omega_I t-\varphi+180°)$ / $\sin(\omega_I t+\varphi')$

X2 — $\sin(\omega_I t-\varphi+90°)$ / $\sin(\omega_I t+\varphi'+90°)$

22f — X3 — $\sqrt{2}\sin(\omega_I t-\varphi+135°)$ / $\sqrt{2}\sin(\omega_I t+\varphi'+45°)$

24f — +45° — X3' — $\sin(\omega_I t-\varphi+180°)$ / $\sin(\omega_I t+\varphi'+90°)$

X4

18f — $Y$ — $\sqrt{2}\sin(\omega_I t+\varphi'+135°)$

20

FIG.10.

$$x$$

$$\sin[(\omega_0-\omega_I)t+\varphi]$$
$$\sin[(\omega_0+\omega_I)t+\varphi']$$

12

$$2\cos\omega_0 t$$

10 — O.L.

$$2\sin\omega_0 t$$

14

X1 — $\sin(\omega_I t-\varphi+180°)$ / $\sin(\omega_I t+\varphi')$

X2 — $\sin(\omega_I t-\varphi+90°)$ / $\sin(\omega_I t+\varphi'+90°)$

22g — X3 — $\sqrt{2}\sin(\omega_I t-\varphi-135°)$ / $\sqrt{2}\sin(\omega_I t+\varphi'-45°)$

24g — −45° — X3' — $\sin(\omega_I t-\varphi-180°)$ / $\sin(\omega_I t+\varphi'-90°)$

X4

18g — $Y$ — $\sqrt{2}\sin(\omega_I t+\varphi'-135°)$

20

19

# FIG.11.

# FIG.12.

FIG. 13.

FIG.14.